# FASCICULE DE BREVET EUROPEEN

(11) **EP 2 210 276 B1**
(45) Date de publication et mention de la délivrance du brevet: **24.07.2013**
(21) Numéro de dépôt: 08842986.5
(22) Date de dépôt: 08.10.2008
(51) Int. Cl.: H01L 31/0224, H01L 31/032, H01L 27/01, C03C 17/40, H01L 31/0392

(54) **Procédé de fabrication d'une électrode en oxyde de molybdène**
Verfahren zur Herstellung einer Elektrode mit Molybdänoxid
Method for producing an electrode made with molybdenum oxide

(30) Priorité: 12.10.2007 FR 0758271
(43) Date de publication de la demande: 28.07.2010
(73) Titulaire: Saint-Gobain Glass France, 92400 Courbevoie (FR)
(72) Inventeur: AUVRAY, Stéphane, F-92150 Suresnes (FR); JANKE, Nikolas, F-52134 Herzogenrath (DE)
(74) Mandataire: Neuviale, Bertrand
(86) Numéro de dépôt international: PCT/FR2008/051817
(87) Numéro de publication internationale: WO 2009/053608

(56) Documents cités:
- WO-A2-2008/156521
- WO-A2-2008/156556
- US-A1- 2007 151 862
- US-A1- 2007 193 623
- US-B1- 6 372 538
- ASSMANN L ET AL: "Study of the Mo thin films and Mo/CIGS interface properties" 15 juin 2005 (2005-06-15), APPLIED SURFACE SCIENCE, ELSEVIER, AMSTERDAM, NL, PAGE(S) 159 - 166 , XP004872641 ISSN: 0169-4332 abrégé alinéas [0001], [03.1]
- BODEGARD M ET AL: "The behaviour of Na implanted into Mo thin films during annealing" 1 juin 1999 (1999-06-01), SOLAR ENERGY MATERIALS AND SOLAR CELLS, ELSEVIER SCIENCE PUBLISHERS, AMSTERDAM, NL, PAGE(S) 199 - 208 , XP004177955 ISSN: 0927-0248 abrégé alinéas [0001], [0003], [04.1], [04.2]
- PALM J ET AL: "CIS module pilot processing applying concurrent rapid selenization and sulfurization of large area thin film precursors" 1 mai 2003 (2003-05-01), THIN SOLID FILMS, ELSEVIER-SEQUOIA S.A. LAUSANNE, CH, PAGE(S) 514 - 522 , XP004428698 ISSN: 0040-6090 abrégé alinéas [0001], [03.1] - [03.3]; figures 2-6
- BODEG @?9RD M ET AL: "Growth of Cu(In,Ga)Se2 thin films by coevaporation using alkaline precursors" 1 février 2000 (2000-02-01), THIN SOLID FILMS, ELSEVIER-SEQUOIA S.A. LAUSANNE, CH, PAGE(S) 9 - 16 , XP004187433 ISSN: 0040-6090 abrégé alinéas [0001], [0002]; figure 1
- SCHMID D ET AL: "A comprehensive characterization of the interfaces in Mo/CIS/CdS/ZnO solar cell structures" 1 juin 1996 (1996-06-01), SOLAR ENERGY MATERIALS AND SOLAR CELLS, ELSEVIER SCIENCE PUBLISHERS, AMSTERDAM, NL, PAGE(S) 281 - 294 , XP004007947 ISSN: 0927-0248 abrégé alinéas [0001], [0002], [03.1], [03.2]; figures 1-4

## Description

La présente invention concerne un substrat pourvu d'un élément conducteur, notamment destiné à constituer une électrode entrant dans la constitution d'une cellule solaire, ainsi qu'un procédé de fabrication de celui-ci.

On sait que, dans la construction de certaines cellules solaires, on fait appel à un substrat non conducteur, habituellement constitué d'un verre standard silico-sodo-calcique, sur la face interne (dite face air) duquel est déposée une électrode conductrice, dite électrode arrière, qui est destinée à venir en parfaite adhérence avec un agent absorbeur.

Ce dernier peut être préférentiellement constitué de composés ternaires chalcopyrites qui contiennent généralement du cuivre, de l'indium et du sélénium. Il s'agit là de ce que l'on appelle des couches d'agent absorbeur CISe₂. On peut aussi ajouter à la couche d'agent absorbeur du gallium (ex : Cu(In,Ga)Se₂ ou CuGaSe₂), de l'aluminium (ex : Cu(In,Al)Se₂), ou du soufre (ex : CuIn(Se,S). On les désigne en général et ci-après par le terme de couches d'agent absorbeur à chalcopyrite.

On comprend que l'électrode arrière, entre autres qualités, doit posséder une résistance électrique la plus faible possible. C'est pourquoi, en raison des nombreux avantages qu'il représente, notamment au niveau de sa faible résistivité, ainsi que de sa bonne résistance au sélénium et au soufre, le molybdène, malgré son prix élevé, est généralement choisi pour constituer l'électrode arrière des cellules solaires.

On sait par ailleurs que les hautes performances requises pour ce type de cellules ne peuvent être atteintes que par une maîtrise rigoureuse de la croissance cristalline de la couche d'agent absorbeur à chalcopyrite. Or, on sait que la croissance des grains de celui-ci est très nettement améliorée par la présence de sodium (Na) en quantité maîtrisée au niveau de l'interface molybdène/agent absorbeur, permettant de réduire la densité des défauts de l'absorbeur et d'augmenter sa conductivité.

Le Na nécessaire peut être d'origine externe et provenir d'un apport, notamment de NaF, Na₂O₂, Na₂Se, ou d'origine interne, à savoir provenir du substrat de verre lui-même, qui assure alors la fonction de réservoir de Na. Suivant cette dernière technique, une couche de molybdène perméable au Na est déposée sur le substrat de verre, de préférence un verre silico-sodo-calcique, et, lors du recuit thermique auquel, de façon classique, celui-ci est soumis lors du procédé de fabrication de la cellule, le Na diffuse librement du substrat vers l'interface Mo/agent absorbeur où il est alors apte à assurer la fonction précédemment mentionnée.

L'une des difficultés rencontrées lors de la mise en oeuvre de cette technique est que, sur le plan pratique, il n'est possible de maîtriser que de façon partielle et peu précise la quantité de Na qui diffuse à travers la couche de molybdène lors de l'opération de recuit.

Certaines des causes de cette difficulté sont bien connues, qui sont d'une part la répartition non uniforme du Na à la surface du substrat de verre et, d'autre part, l'inhomogénéité des propriétés de la couche de molybdène déposée sur celui-ci.

Or il a été constaté et démontré que la teneur en Na de la couche de molybdène d'une cellule solaire est très fortement corrélée à la teneur en oxyde de molybdène de cette couche.

On peut donc en conclure que la teneur en Na, et donc la qualité cristalline de la couche d'agent absorbeur à chalcopyrite, est fortement liée à la maîtrise de la teneur en oxygène des couches de molybdène. Le document US 6 372 538 décrit une électrode à base de molybdène enrichie en oxygène sur un substrat en polyimide.

La présente invention a pour but de proposer un substrat et son procédé de fabrication permettant de maîtriser la teneur du Na susceptible de diffuser dans les couches actives supérieures d'une cellule solaire lors de la fabrication de celle-ci.

La présente invention a pour objet un procédé de fabrication d'un substrat selon la revendication 1, ainsi qu'un procédé de fabrication d'une cellule solaire selon la revendication 2.

Dans des modes de réalisation préférés de l'invention, on peut éventuellement avoir recours en outre à l'une et/ou à l'autre des dispositions suivantes :
- l'argon utilisé est celui mis en oeuvre pour assurer la pulvérisation magnétron,
- l'on forme la couche enrichie en oxyde de molybdène sur ladite face interne de l'élément conducteur en effectuant un recuit thermique de la couche de molybdène en présence dudit composé oxygéné.

On décrira ci-après, à titre d'exemple non limitatif, une forme d'exécution de la présente invention, en référence au dessin annexé sur lequel :
- la figure 1 est un graphique établissant la relation existant entre les teneurs respectives en sodium et en oxygène d'une couche à base de molybdène d'une électrode arrière d'une cellule solaire, et ceci pour différents instants de production de l'électrode,
- la figure 2 est une représentation schématique d'une cellule solaire réalisée conformément au procédé suivant l'invention,
- la figure 3 est une représentation schématique d'un dispositif de pulvérisation magnétron,
- la figure 4 est une représentation schématique d'un substrat revêtu d'une couche de molybdène entre lesquels une sous couche d'oxyde de molybdène est déposée,
- la figure 5 est une représentation schématique d'un substrat revêtu d'une couche de molybdène elle-même revêtue d'une couche d'oxyde de molybdène,
- la figure 6 est un graphique représentant le profil SIMS (Spectroscopie de masse à ionisation secondaire) pour le sodium, respectivement d'un substrat de verre revêtu d'une couche de molybdène et d'un même substrat de verre recouvert d'une couche de molybdène et d'une couche d'oxyde de molybdène,
- la figure 7 est un graphique représentant les teneurs respectives en Na et en O d'un élément conducteur de molybdène formé respectivement de quatre, huit et seize couches.

Suivant la présente invention, on réalise une cellule solaire à partir d'un substrat transparent 1' que, dans un premier temps, on recouvre d'un élément conducteur 2 destiné à constituer, dans le présent mode de mise en oeuvre, une électrode dite électrode arrière de la cellule.

Le substrat l'est constitué préférentiellement d'un verre silico-sodo-calcique dont l'essentiel de la masse (c'est-à-dire pour au moins 98 % en masse), voire la totalité de celle-ci est constituée de matériau(x) présentant la meilleure transparence possible et ayant de préférence une absorption linéique inférieure à 0,01 mm⁻¹ dans la partie du spectre utile à l'application (cellule solaire), généralement le spectre allant de 380 à 1200 nm.

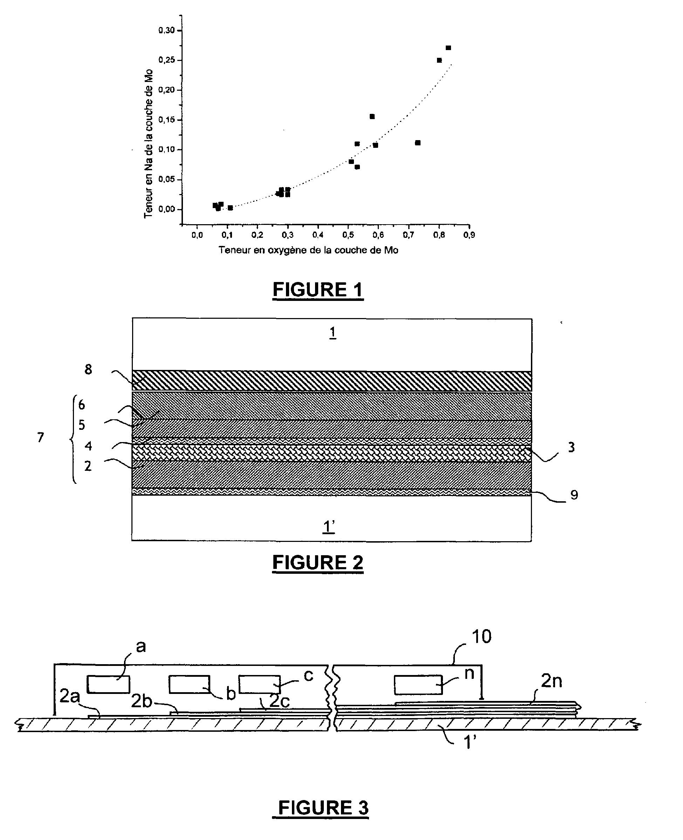

Suivant un mode préféré de mise en oeuvre de la présente invention l'électrode 2 à base de molybdène est déposée sur le substrat de verre 1' par un procédé de pulvérisation magnétron, bien connu dans ce type de technique, et qui est représenté sous forme schématique sur la figure 3. Ce procédé fait ainsi appel à plusieurs cibles de molybdène a, b, c, d, ... n au-dessous desquelles défile le substrat de verre 1' à recouvrir, réalisant ainsi une épaisseur de molybdène formée de n couches respectives 2a, 2b, 2c,... 2n, correspondant à chacune des cibles utilisées.

La technique de formation de l'électrode sur le substrat 1' par pulvérisation magnétron permet de donner à chacune des couches formant l'épaisseur de l'électrode 2 des caractéristiques spécifiques parfaitement contrôlées.

Or il a été établi par les inventeurs que la teneur en sodium existant dans la couche de molybdène, suite à la migration du Na, est très fortement corrélée à la teneur en oxyde de molybdène de celle-ci. Cette corrélation apparaît sur la figure 1 qui représente la valeur de la teneur en Na de cette couche en fonction de la valeur de sa teneur en oxygène et ceci pour différents points correspondant à des couches de molybdène déposées sur le substrat à différentes heures de production. Sur cette courbe chaque point correspond aux mesures dites SIMS de la teneur en sodium et en oxygène effectuées sur un même échantillon.

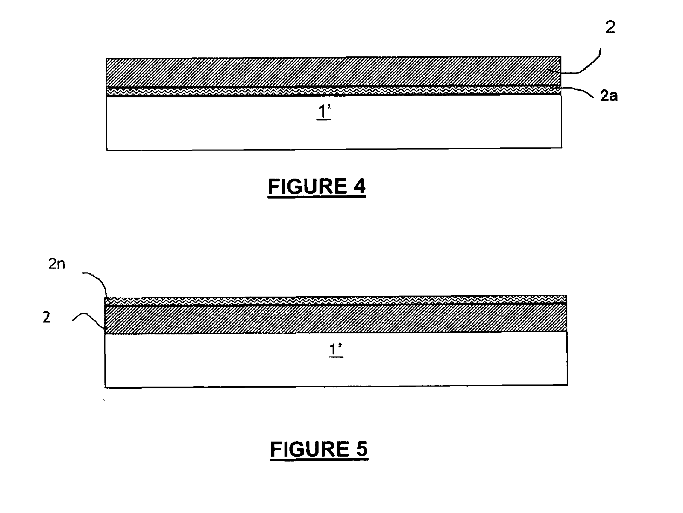

Dans un premier mode de mise en oeuvre de l'invention on souhaite réaliser un substrat tel que celui représenté sur la figure 4 dans lequel une couche 2a de molybdène enrichie d'oxyde de molybdène est déposée en contact avec le verre 1', cette couche étant recouverte ensuite de plusieurs autres couches de façon à constituer l'électrode 2 à base de molybdène.

Pour ce faire, on a injecté sur la première cible a de la machine 10, et conjointement à l'argon utilisé de façon connue pour la mise en oeuvre du processus de pulvérisation magnétron, un flux d'un composé oxygéné tel que de l'oxygène, ou de l'ozone O₃ ou d'un mélange de gaz contenant de l'oxygène sous forme atomique, tel que le dioxyde de carbone CO ou de la vapeur d'eau H₂O ou un mélange argon/ composé oxygéné ait une faible teneur en oxygène, préférentiellement de l'ordre de 100 ppm. Dans cet exemple de mise en oeuvre de l'invention, cette injection est réalisée en insérant sur la ligne d'alimentation en argon existante de l'installation, une alimentation secondaire dudit composé en oxygène permettant de contrôler de façon précise, la pression, le débit et la teneur du composé à base d'oxygène/d'argon injecté.

On obtient ainsi une première couche de molybdène 2a, ou sous-couche, qui est enrichie en oxyde de molybdène et qui est recouverte d'une série de couches superposées de molybdène formant l'électrode 2, ainsi que représenté sur la figure 4.

Dans ce mode de mise en oeuvre la conductivité de la sous couche, dont on comprend que sa conductivité diminue dès lors qu'elle est davantage dopée en oxygène, ne constitue pas un paramètre critique dans la mesure où la conductivité sera donnée par l'électrode 2. En conséquence la teneur en oxygène de l'oxyde de molybdène pourra être élevée, de l'ordre de 1 à 75%, préférentiellement 20 à 75 % d'oxygène atomique , ce qui assurera un bon « pompage » du Na.

Pour constituer la cellule, on dépose ensuite, de façon connue, sur cette électrode 2 une couche fonctionnelle 3 à base d'agent absorbeur à chalcopyrite, elle-même revêtue d'une fine couche 4 de sulfure de cadmium (CdS) permettant de créer avec la couche à chalcopyrite une jonction pn. En effet, l'agent chalcopyrite est généralement dopé n, la couche de CdS étant dopée p, cela permet de créer la jonction pn nécessaire à l'établissement d'un courant électrique. Enfin on recouvre la couche de CdS d'une couche d'accrochage 5 formée d'oxyde de zinc dit intrinsèque (ZnO : i).

Afin de former la seconde électrode de la cellule, la couche de ZnO :i est recouverte d'une couche 6 d'oxyde conducteur transparent dit TCO pour « Transparent Conductive Oxide ». Cette couche conductrice 6 doit être aussi transparente que possible, et présenter une transmission élevée de la lumière dans l'ensemble des longueurs d'onde correspondant au spectre d'absorption du matériau constituant la couche fonctionnelle, afin de ne pas réduire inutilement le rendement de la cellule solaire.

L'empilement 7 de ces différentes couches minces se termine par un substrat transparent 1, supérieur sur le dessin, avec interposition d'un intercalaire de feuilletage 8 par exemple en polyuréthane (PU), en polyvinyle-butyral (PVB), ou en éthylène-acétate de vinyle (EVA), l'ensemble étant, de façon connue, encapsulé périphériquement à l'aide d'un joint ou d'une résine d'étanchéité. On obtient ainsi la cellule solaire représentée sur la figure 2.

Dans le présent mode de mise en oeuvre de l'invention, lors de l'étape de recuit nécessaire à la cristallisation de l'agent absorbeur à chalcopyrite le Na présent dans le substrat de verre se trouve ainsi « pompé » jusqu'à saturation par la sous-couche 2a d'oxyde de molybdène, jusqu'à saturation de celle-ci, avec pour effet une homogénéisation de la répartition du Na à son interface avec l'électrode 2 à base de molybdène. On a ainsi suivant l'invention créé un « réservoir » de Na qui garantit un apport constant de ce dernier et une teneur assurant une bonne cristallisation de l'agent absorbeur à chalcopyrite 3 lors de l'étape de recuit.

La présente invention permet ainsi de produire un substrat revêtu de son électrode qui est de qualité constante et possède une teneur en Na qui est garantie et paramétrable, et donc totalement maîtrisée, permettant ainsi d'éviter l'étape habituelle d'enrichissement en Na de la couche de molybdène.

Dans un autre mode de mise en oeuvre de l'invention représenté sur la figure 5 on a déposé la couche d'oxyde de molybdène sur la couche 2 à base de molybdène une fois celle-ci formée sur le substrat 1'. Pour ce faire, à l'inverse du processus précédent, on a réalisé l'oxygénation de la dernière cible n de la machine 10 si bien que la couche enrichie en oxyde de molybdène est la couche 2n déposée sur les couches formant l'électrode 2.

Un tel mode de mise en oeuvre présente deux avantages essentiels. Tout d'abord le « réservoir de Na » se trouve à proximité de la couche d'agent absorbeur à chalcopyrite ce qui garantit une injection en Na qui soit à la fois rapide et en quantité suffisante pour assurer une bonne cristallistion de cet absorbeur. Ensuite, cette solution résout les problèmes de pollution des couches externes du substrat lors du stockage de celui-ci. En effet, on sait que le procédé de fabrication des électrodes à base de molybdène est un procédé continu qui implique que les substrats ainsi revêtus soient stockés en pile sur des chevalets avant leur utilisation ultérieure dans un procédé en reprise au cours duquel la couche à base de matériau absorbant sera déposée sur la surface de l'électrode en molybdène. Or, au cours des phases de stockage des substrats sur les chevalets, la couche à base de molybdène fait face au substrat de verre. Cette face riche en sodium est susceptible de contaminer la face de molybdène et de l'enrichir au cours du temps. Ce mécanisme de dopage non contrôlé peut conduire à une dérive des procédés de fabrication lors de la phase de dépôt du molybdène en reprise. Dans la mesure où, suivant l'invention, la couche externe est saturée en Na il n'y a plus, dès lors, de risque de créer des irrégularités de distribution de Na à la surface de celle-ci.

Dans ce mode de mise en oeuvre la conductivité de la couche enrichie en oxyde de molybdène sera nécessaire si bien qu'il sera intéressant de moins la doper en oxygène. Sa teneur en oxygène atomique pourra alors se situer entre environ 1 à 75%, préférentiellement 5 à 40 % d'oxygène atomique.

La présente invention permet également de distribuer les couches enrichies en oxyde de molybdène suivant un gradient de concentration s'étendant suivant l'épaisseur de l'électrode 2, et ceci en jouant sur une oxygénation contrôlée des cibles a, b, c, ... n de la machine 10 à pulvérisation magnétron. On pourra ainsi avoir un gradient de concentration en oxygène allant de 1% à 75% atomique et inversement.

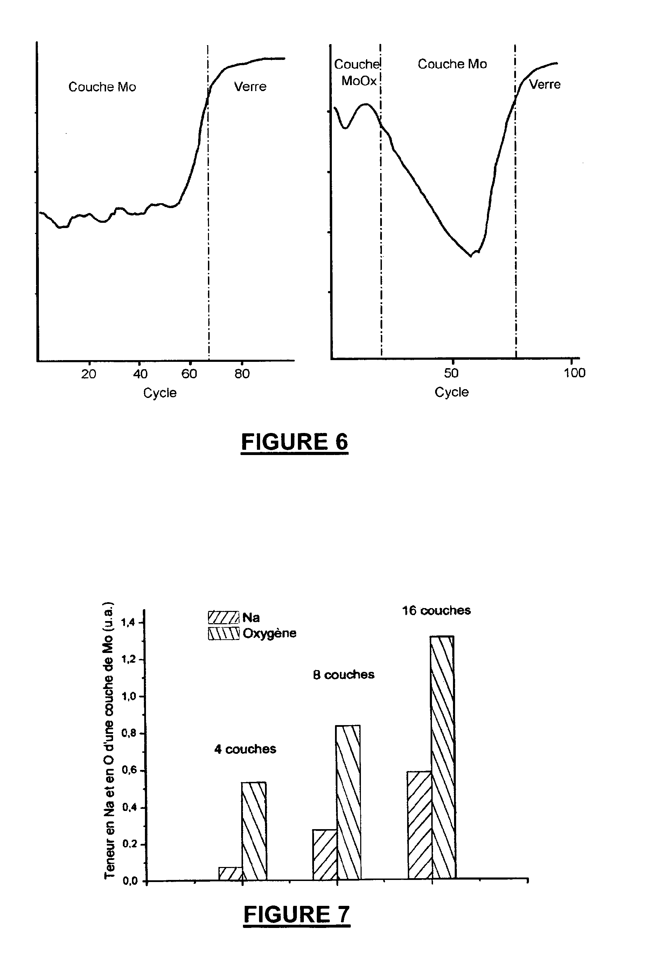

On peut également, suivant l'invention, ajuster la teneur en oxyde de molybdène, et donc en Na, de l'électrode 2 en augmentant le nombre n des cibles utilisée dans la machine 10 à pulvérisation magnétron et donc le nombre de couches déposées susceptibles d'être dopées en oxygène. Il est ainsi possible de réaliser une électrode 2 formée d'une série de couches alternées : Mo // Mo-O // Mo // Mo-O etc... On constate ainsi sur le diagramme de la figure 7 qu'en augmentant le nombre de couches d'une électrode, pour une même épaisseur de cette dernière, on augmente du même coup la teneur en oxygène de celle-ci et en conséquence celle de Na.

Suivant l'invention, la couche d'oxyde de molybdène peut être formée sur le substrat l'et/ou sur la surface libre de l'élément conducteur à base de molybdène, à savoir l'électrode 2, par tout autre procédé que la pulvérisation magnétron. Elle peut notamment être formée sur l'électrode 2 de molybdène en formant une oxydation surfacique de celle-ci en réalisant son recuit thermique en présence du composé oxygéné.

On a représenté sur la figure 6 le profil SIMS pour le sodium, respectivement d'un substrat de verre revêtu d'une couche de molybdène et d'un substrat de verre suivant l'invention sur lequel on a déposé une couche à base de molybdène dont la surface a été recouverte d'une couche d'oxyde de molybdène par le procédé de recuit thermique. On constate l'apparition sur cette dernière courbe d'un large pic de Na établissant la présence de celui-ci au niveau de la couche d'oxyde de molybdène.

Bien entendu, suivant l'invention on pourrait déposer ladite sous-couche d'oxyde de molybdène à la fois sur la face interne du substrat, c'est-à-dire sur la face de celui-ci destinée à recevoir la couche de molybdène (interface verre/Mo), et sur la face libre de cette dernière c'est-à-dire la face de celle-ci opposée au substrat (interface air/Mo). Cette variante permettant de cumuler les avantages des deux techniques.

Selon une autre variante de l'invention, l'invention est également applicable dans le cas d'un substrat qui aurait été recouvert, préalablement au dépôt de la couche à base de molybdène, d'une couche destinée à constituer une barrière aux alcalins, et qui pourrait être notamment constituée de nitrures, d'oxydes ou d'oxynitrures de silicium, ou de nitrures, d'oxydes ou d'oxynitrures d'aluminium, ou de nitrures, d'oxydes ou d'oxynitrures de titane, de nitrures, d'oxydes ou d'oxynitrures de zirconium, utilisés seul ou en mélange.

## Revendications

1. Procédé de fabrication d'un substrat en verre (1') dont une face, dite face interne, est destinée à recevoir un élément conducteur (2) à base de molybdène, **caractérisé en ce qu'**il comporte les étapes consistant à former sur le substrat en verre (1') plusieurs couches distinctes à base de molybdène, au moins l'une de ces couches étant enrichie en oxyde de molybdène, la couche enrichie contient entre 1 et 75% d'oxygène atomique
dans lequel l'on forme lesdites couches par un procédé de pulvérisation magnétron,
dans lequel la couche enrichie en oxyde de molybdène est obtenue par une injection d'un composé oxygéné tel que de l'oxygène, ou de l'ozone O₃ ou d'un mélange de gaz contenant de l'oxygène sous forme atomique, tel que le dioxyde de carbone CO₂ ou de la vapeur d'eau H₂O, lors de l'étape de fabrication de l'élément conducteur à base de molybdène,
l'injection étant réalisée en insérant sur la ligne d'alimentation en argon de l'installation, une alimentation secondaire dudit composé en oxygène permettant de contrôler la pression, le débit et la teneur du composé à base d'oxygène/d'argon injecté.

2. Procédé de fabrication d'une cellule solaire utilisant un substrat en verre (1') dont une face, dite face interne, est destinée à recevoir un élément conducteur (2) à base de molybdène, **caractérisé en ce qu'**il comporte les étapes consistant à former sur le substrat en verre (1') plusieurs couches distinctes à base de molybdène, au moins l'une de ces couches étant enrichie en oxyde de molybdène, la couche enrichie contient entre 1 et 75% d'oxygène atomique
dans lequel une couche fonctionnelle (3) à base d'agent absorbeur à chalcopyrite est déposée sur l'élément conducteur (2) à base de molybdène, la couche fonctionnelle (3) à base d'agent absorbeur à chalcopyrite étant elle-même revêtue d'un couche de sulfure de cadmium (CdS) (4) permettant de créer avec la couche à chalcopyrite (3) une jonction pn, la couche de CdS (4) étant recouverte d'une couche d'accrochage (5) formée d'oxyde de zinc intrinsèque (ZnO :i), la couche de ZnO :i (5) étant recouverte d'une couche d'oxyde conducteur transparent (TCO) (6).

3. Procédé suivant la revendication 1 ou 2 **caractérisé en ce que** l'oxygène injecté provient d'un mélange à base d'oxygène et d'argon.

4. Procédé suivant la revendication 3 **caractérisé en ce que** l'argon utilisé est celui mis en oeuvre pour assurer la pulvérisation magnétron.

5. Procédé suivant l'une quelconque des revendications précédentes **caractérisé en ce que** ladite couche enrichie est formée sur la face de l'élément conducteur (2) en contact avec le substrat (1').

6. Procédé suivant la revendication 5 **caractérisé en ce que**, la couche enrichie contient entre 20 et 75% d'oxygène atomique.

7. Procédé suivant l'une quelconque des revendications 1 à 4 **caractérisé en ce que** ladite couche enrichie est formée sur la face libre de l'élément conducteur (2).

8. Procédé suivant la revendication 7 **caractérisé en ce que** la couche enrichie contient entre 5 et 40% d'oxygène atomique.

9. Procédé suivant l'une des revendications précédentes **caractérisé en ce que** plusieurs couches enrichies sont disposées suivant l'épaisseur de l'élément conducteur (2).

10. Procédé suivant la revendication 9 **caractérisé en ce que** les couches enrichies se distribuent de façon superposée dans l'épaisseur de l'élément conducteur (2) suivant un gradient de concentration en oxyde de molybdène.

11. Procédé suivant l'une des revendications 9 ou 10 **caractérisé en ce que** la couche de concentration maximale en oxyde de molybdène est en contact avec le substrat (1').

12. Procédé suivant l'une des revendications 9 ou 10 **caractérisé en ce que** la couche de concentration maximale en oxyde de molybdène se situe au niveau de la face libre de l'élément conducteur (2).

13. Procédé suivant l'une des revendications 11 ou 12 **caractérisé en ce que** le gradient de concentration en oxygène atomique s'étend entre 1 à 75%.

14. Procédé suivant l'une des revendications précédentes **caractérisé en ce que** l'oxyde de molybdène est constitué de MoO et/ou de MoO₂ et/ou de MoO₃ sur ou sous-stoechiométrique en fonction de la teneur en oxygène

15. Procédé suivant l'une des revendications précédentes **caractérisé en ce que** l'élément conducteur (2) constitue une électrode d'une cellule photoélectrique.

16. Procédé suivant l'une quelconque des revendications précédentes **caractérisé en ce qu'**une couche barrière est déposée préalablement à la couche en molybdène, ladite couche barrière étant destinée à constituer une barrière aux alcalins, la couche barrière pouvant être notamment constituée de nitrures, d'oxydes ou d'oxynitrures de silicium, ou de nitrures, d'oxydes ou d'oxynitrures d'aluminium, ou de nitrures, d'oxydes ou d'oxynitrures de titane, de nitrures, d'oxydes ou d'oxynitrures de zirconium, utilisés seul ou en mélange.

## Patentansprüche

1. Verfahren zur Herstellung eines Glassubstrats (1'), dessen eine Seite, sogenannte Innenseite, dazu bestimmt ist, ein leitendes Element (2) auf Molybdänbasis aufzunehmen, **dadurch gekennzeichnet, dass** es die Schritte umfasst, die darin bestehen, auf dem Glassubstrat (1') mehrere unterschiedliche Schichten auf Molybdänbasis auszubilden, wobei wenigstens eine dieser Schichten mit Molybdänoxid angereichert ist, wobei die angereicherte Schicht zwischen 1 und 75 % atomaren Sauerstoff enthält,
wobei die Schichten mittels eines Magnetronzerstäubungsverfahrens ausgebildet werden,
wobei die mit Molybdänoxid angereicherte Schicht durch ein Einleiten einer sauerstoffhaltigen Verbindung, wie Sauerstoff oder Ozon O₃, oder eines Gasgemischs, das Sauerstoff in atomarer Form enthält, wie Kohlendioxid CO₂ oder Wasserdampf H₂O, während des Schrittes zur Herstellung des leitenden Elements auf Molybdänbasis erhalten wird,
wobei das Einleiten dadurch vollzogen wird, dass an der Argon-Zuführleitung der Anlage eine Nebenzuleitung der Sauerstoff-Verbindung eingefügt wird, die ermöglicht, den Druck, die Durchflußmenge und den Gehalt der eingeleiteten Verbindung auf Sauerstoff-/Argonbasis zu steuern.

2. Verfahren zur Herstellung einer Solarzelle, das ein Glassubstrat (1') verwendet, dessen eine Seite, sogenannte Innenseite, dazu bestimmt ist, ein leitendes Element (2) auf Molybdänbasis aufzunehmen, **dadurch gekennzeichnet, dass** es die Schritte umfasst, die darin bestehen, auf dem Glassubstrat (1') mehrere unterschiedliche Schichten auf Molybdänbasis auszubilden, wobei wenigstens eine dieser Schichten mit Molybdänoxid angereichert ist, wobei die angereicherte Schicht zwischen 1 und 75 % atomaren Sauerstoff enthält,
wobei eine Funktionsschicht (3) auf Basis eines Chalkopyrit-Absorbers auf dem leitenden Element (2) auf Molybdänbasis abgeschieden wird, wobei die Funktionsschicht (3) auf Basis eines Chalkopyrit-Absorbers selbst mit einer Schicht aus Cadmiumsulfid (CdS) (4) überzogen ist, die ermöglicht, mit der Chalkopyrit-Schicht (3) einen pn-Übergang zu bilden, wobei die Cds-Schicht (4) mit einer aus intrinsischem Zinkoxid (ZnO :i) gebildeten Haftschicht (5) überzogen ist, wobei die ZnO :i-Schicht (5) mit einer Schicht aus transparentem leitendem Oxid (TCO) (6) überzogen ist.

3. Verfahren nach Anspruch 1 oder 2, **dadurch gekennzeichnet, dass** der eingeleitete Sauerstoff aus einem Gemisch auf Sauerstoff- und Argonbasis stammt.

4. Verfahren nach Anspruch 3, **dadurch gekennzeichnet, dass** das verwendete Argon dasjenige ist, das zur Sicherstellung der Magnetronzerstäubung eingesetzt wird.

5. Verfahren nach einem der vorstehenden Ansprüche, **dadurch gekennzeichnet, dass** die angereicherte Schicht auf der mit dem Substrat (1') in Kontakt befindlichen Seite des leitenden Elements (2) ausgebildet ist.

6. Verfahren nach Anspruch 5, **dadurch gekennzeichnet, dass** die angereicherte Schicht zwischen 20 und 75 % atomaren Sauerstoff enthält.

7. Verfahren nach einem der Ansprüche 1 bis 4, **dadurch gekennzeichnet, dass** die angereicherte Schicht auf der freien Seite des leitenden Elements (2) ausgebildet ist.

8. Verfahren nach Anspruch 7, **dadurch gekennzeichnet, dass** die angereicherte Schicht zwischen 5 und 40 % atomaren Sauerstoff enthält.

9. Verfahren nach einem der vorstehenden Ansprüche, **dadurch gekennzeichnet, dass** mehrere angereicherte Schichten entlang der Dicke des leitenden Elements (2) angeordnet sind.

10. Verfahren nach Anspruch 9, **dadurch gekennzeichnet, dass** die angereicherten Schichten in übereinander liegender Weise in der Dicke des leitenden Elements (2) entsprechend einem Molybdänoxidkonzentrationsgradienten verteilt sind.

11. Verfahren nach einem der Ansprüche 9 oder 10, **dadurch gekennzeichnet, dass** die Schicht mit maximaler Molybdänoxidkonzentration mit dem Substrat (1') in Kontakt ist.

12. Verfahren nach einem der Ansprüche 9 oder 10, **dadurch gekennzeichnet, dass** die Schicht mit maximaler Molybdänoxidkonzentration im Bereich der freien Seite des leitenden Elements (2) gelegen ist.

13. Verfahren nach einem der Ansprüche 11 oder 12, **dadurch gekennzeichnet, dass** der Gradient der Konzentration an atomarem Sauerstoff zwischen 1 und 75 % verläuft.

14. Verfahren nach einem der vorstehenden Ansprüche, **dadurch gekennzeichnet, dass** das Molybdänoxid von MoO und/oder von MoO₂ und/oder von MoO₃, über- oder unterstöchiometrisch in Abhängigkeit des Sauerstoffgehalts, gebildet ist.

15. Verfahren nach einem der vorstehenden Ansprüche, **dadurch gekennzeichnet, dass** das leitende Element (2) eine Elektrode einer photoelektrischen Zelle bildet.

16. Verfahren nach einem der vorstehenden Ansprüche, **dadurch gekennzeichnet, dass** vor der Molybdänschicht eine Sperrschicht abgeschieden wird, wobei die Sperrschicht dazu bestimmt ist, eine Alkalibarriere zu bilden, wobei die Sperrschicht insbesondere von Siliziumnitriden, -oxiden oder -oxinitriden, oder von Aluminiumnitriden, -oxiden oder -oxinitriden, oder von Titannitriden, -oxiden oder -oxinitriden, von Zirkoniumnitriden, -oxiden oder -oxinitriden, allein oder als Mischung verwendet, gebildet sein kann.

## Claims

1. Method for producing a glass substrate (1'), of which one face, called the inner face, is designed to receive a conductive element (2) based on molybdenum, **characterized in that** it comprises steps consisting of forming several distinct layers based on molybdenum on the glass substrate (1'), at least one of these layers being enriched in molybdenum oxide, the enriched layer contains between 1 and 75% atomic oxygen
in which said layers are formed by a magnetron sputtering method,
in which the layer enriched with molybdenum oxide is obtained by injecting an oxygenated compound such as oxygen, ozone O₃ or mixture of gases containing oxygen in the atomic form such as carbon dioxide CO₂ or water vapor H₂O, during the step of producing the molybdenum-based conductive element,
the injection being carried out by inserting a secondary feed of said oxygenated compound on the argon feed line of the installation, making it possible to control the pressure, flow rate and concentration of the oxygen-based compound/argon injected.

2. Method for producing a solar cell using a glass substrate (1'), of which one face, called the inner face, is designed to receive a molybdenum-based conductive element (2), **characterized in that** it comprises steps consisting of forming several distinct layers based on molybdenum on the glass substrate (1'), at least one of these layers being enriched with molybdenum oxide, the enriched layer contains between 1 and 75% atomic oxygen
in which a functional layer (3) based on a chalcopyrite absorbing agent is deposited on the molybdenum-based conductive element (2), the functional layer (3) based on a chalcopyrite absorbing agent being itself coated with a layer (4) of cadmium sulfide (CdS) enabling a pn junction to be created with the chalcopyrite layer (3), the CdS layer (4) being covered with a tie layer (5) formed of intrinsic zinc oxide (ZnO:i), the ZnO:i layer (5) being covered with a layer (6) of a transparent conductive oxide (TCO).

3. Method according to Claim 1 or 2, **characterized in that** the oxygen injected comes from a mixture based on oxygen and argon.

4. Method according to Claim 3, **characterized in that** the argon used is that employed for providing magnetron sputtering.

5. Method according to any one of the preceding claims, **characterized in that** said enriched layer is formed on the face of the conductive element (2) in contact with the substrate (1').

6. Method according to Claim 5, **characterized in that** the enriched layer contains between 20 and 75% atomic oxygen.

7. Method according to any one of Claims 1 to 4, **characterized in that** said enriched layer is formed on the free face of the conductive element (2).

8. Method according to Claim 7, **characterized in that** the enriched layer contains between 5 and 40% atomic oxygen.

9. Method according to one of the preceding claims, **characterized in that** several enriched layers are disposed following the thickness of the conductive element (2).

10. Method according to Claim 9, **characterized in that** the enriched layers are distributed in a superimposed manner in the thickness of the conductive element (2) following a concentration gradient in molybdenum oxide.

11. Method according to either of Claims 9 or 10, **characterized in that** the layer with the maximum concentration of molybdenum oxide is in contact with the substrate (1').

12. Method according to either of Claims 9 or 10, **characterized in that** the layer with the maximum concentration of molybdenum oxide is situated at the level of the free face of the conductive element (2).

13. Method according to either of Claims 11 or 12, **characterized in that** the concentration gradient of atomic oxygen extends from 1 to 75%.

14. Method according to one of the preceding claims, **characterized in that** the molybdenum oxide consists of MoO and/or MoO₂ and/or MoO₃, over- or sub-stoichiometric according to the oxygen content.

15. Method according to one of the preceding claims, **characterized in that** the conductive element (2) constitutes an electrode of a photoelectric cell.

16. Method according to any one of the preceding claims, **characterized in that** a barrier layer is deposited prior to the molybdenum layer, said barrier layer being designed to constitute a barrier to alkalis, the barrier layer notably being able to consist of silicon nitrides, oxides or oxynitrides, or aluminum nitrides, oxides or oxynitrides, or titanium nitrides, oxides or oxynitrides, or zirconium nitrides, oxides or oxynitrides, used alone or mixed.
